# FASCICULE DE BREVET EUROPEEN

(11) **EP 0 432 058 B1**
(45) Date de publication et mention de la délivrance du brevet: **15.02.1995**
(21) Numéro de dépôt: 90420507.7
(22) Date de dépôt: 22.11.1990
(51) Int. Cl.: H01L 27/02, H03K 17/08

(54) **Circuit d'isolation dynamique de circuits intégrés**
Dynamische Isolierschaltung für integrierte Schaltungen
Dynamic isolation circuit for integrated circuits

(30) Priorité: 29.11.1989 FR 8916144
(43) Date de publication de la demande: 12.06.1991
(73) Titulaire: SGS-THOMSON MICROELECTRONICS S.A., 94250 Gentilly (FR); SIEMENS AUTOMOTIVE S.A., 31036 Toulouse Cédex (FR)
(72) Inventeur: Pavlin, Antoine, F-13540 Puyricard (FR); Sicard, Thierry, F-31150 Fenouillet (FR); Simon, Marc, F-31170 Tournefeuille (FR)
(74) Mandataire: de Beaumont, Michel

(56) Documents cités:
- DE-A- 3 507 181
- US-A- 4 303 958

## Description

La présente invention concerne le domaine des circuits intégrés et plus particulièrement des circuits intégrés comprenant des transistors latéraux et des transistors verticaux, dans lesquels les transistors latéraux sont isolés individuellement ou en groupes par jonction.

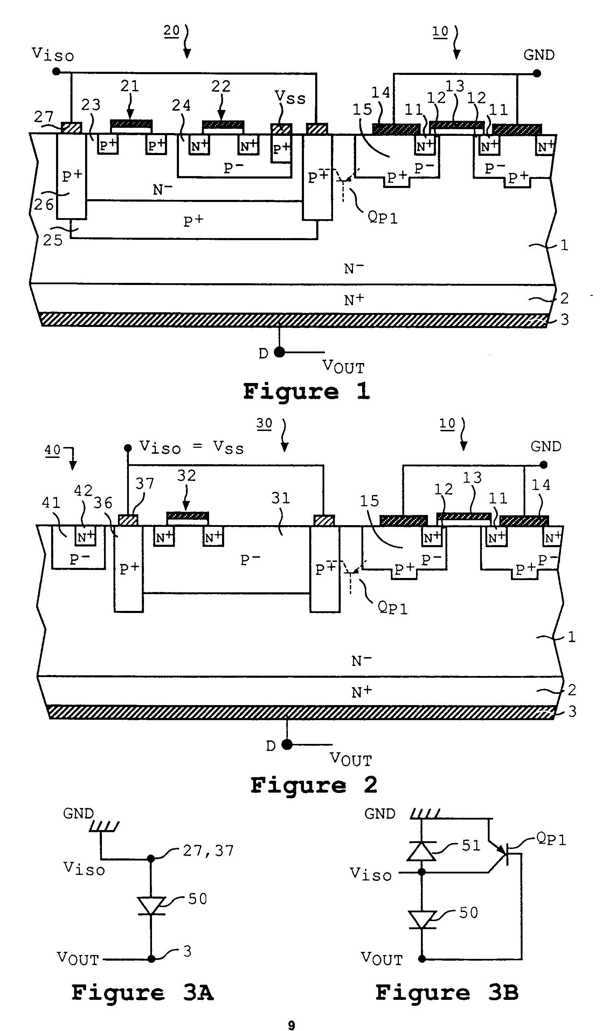

Pour situer le problème posé, deux exemples de configurations classiques de circuits intégrés comprenant des transistors verticaux et des transistors latéraux vont être rappelés en relation avec les figures 1 et 2.

La figure 1 représente un circuit intégré formé dans un substrat 1 de type N sur la face arrière duquel est prévue une zone de surdopage N⁺ 2 qui est revêtue d'une métallisation 3. Dans la partie droite de la figure est illustrée une cellule 10 de transistor MOS à canal N vertical et dans la partie gauche de la figure une partie logique, ou partie signal, 20, dans laquelle sont formés des transistors MOS à canal N et canal P latéraux.

Le transistor MOS vertical 10 comprend des régions de source 11 formées dans des régions de canal 12 surmontées par une grille isolée 13. Les régions de source 11 sont solidaires d'une métallisation de source 14 également en contact avec la région de caisson 15 dont une partie constitue la région de canal 12. De façon classique, un transistor vertical de puissance (VDMOS) est constitué d'un grand nombre de cellules en parallèle telles que la cellule 10.

La partie logique 20 comprend des transistors MOS a canal P 21 et des transistors MOS à canal N 22. Ces transistors sont formés dans un caisson de type N 23 (les transistors à canal N étant formés dans un deuxième caisson 24 disposé dans le caisson 23). L'ensemble de la partie logique est isolé par jonction au moyen de régions dopées P⁺ formant d'une part une couche enterrée 25, d'autre part des puits latéraux 26 rejoignant la couche enterrée 25. La structure d'isolement 25, 26 est reliée par sa partie supérieure à des métallisations d'isolement 27 connectées à un potentiel d'isolement Vᵢₛₒ.

La figure 2 représente une autre structure classique de circuit intégré composant des composants verticaux et latéraux. Dans cette figure, des éléments analogues à ceux de la figure 1 sont désignés par de mêmes références numériques.

La partie droite de la figure 2, correspondant à une cellule d'un transistor MOS vertical à canal N, est identique à la partie droite de la figure 1.

La partie de transistors logiques est maintenant désignée par la référence 30. Elle est formée dans un caisson P⁻ 31 de type de conductivité opposé à celui du substrat. On y a représenté seulement un transistor à canal N 32. Le caisson P⁻ est bordé par un puits d'isolement de type P⁺ 36 relié à une métallisation d'isolement 37 relié à un potentiel d'isolement Vᵢₛₒ. Dans cette configuration, Vᵢₛₒ est égal au potentiel de référence VSS de la partie signal.

On a en outre représenté en figure 2, un transistor bipolaire vertical 40 comprenant une région de base de type P⁻41 et une région d'émetteur de type N⁺ 42. Le collecteur de ce transistor vertical correspond au drain du transistor MOS vertical et la métallisation de collecteur sera donc la métallisation de face arrière 3. On notera qu'un transistor NPN vertical pourrait également avoir été prévu dans la structure de la figure 1.

Les figures 1 et 2 ont été représentées de façon extrêmement schématiques et sont destinées uniquement à exposer le problème lié à l'isolement des régions de transistors latéraux (partie signal ou partie logique).

Dans un mode de fonctionnement usuel d'un transistor de puissance vertical, les sources des transistors MOS verticaux (VDMOS) ou les émetteurs des transistors NPN verticaux sont reliés à la masse et les drains des VDMOS et les collecteurs des transistors NPN verticaux (face arrière) sont reliés à la haute tension positive. Les circuits logiques fonctionnent normalement entre le niveau de la masse et une tension d'alimentation positive (VCC). Pour que les caissons des transistors latéraux soient convenablement isolés, il convient alors que le potentiel d'isolement Vᵢₛₒ soit le potentiel le plus négatif du circuit, c'est-à-dire la masse. En ce cas, comme l'illustre très schématiquement la figure 3A, la borne 27 (figure 1) ou la borne 37 (figure 2) est reliée à la masse et la diode P⁺N 50 entre la région d'isolement (25, 26 ; 36) et la face arrière est en inverse entre la haute tension positive Vₒᵤₜ et la masse. Le circuit est alors convenablement isolé.

Toutefois, il est possible que de façon transitoire la tension Vₒᵤₜ appliquée à la métallisation de face arrière 3 devienne négative, par exemple par suite d'une commutation ou de parasites. Alors, la diode d'isolement 50 illustrée en figure 3A est polarisée en direct. Il en résulte de nombreux inconvénients bien connus, à savoir :
- une circulation de courants parasites importants dans la zone logique ou de signal,
- une consommation élevée sur l'alimentation de la partie signal,
- un risque de latch-up d'éventuelles structures CMOS contenues dans le ou les caissons logiques,
- un changement éventuel d'état de certains circuits logiques tels que des points mémoires, des compteurs, etc.

Pour pallier ces inconvénients, on a proposé dans l'art antérieur de relier le potentiel d'isolement Vᵢₛₒ à la masse non plus directement mais par l'intermédiaire d'une diode 51, comme cela est représenté en figure 3B. On bloque donc ainsi normalement la circulation de courant entre la région d'isolement et la face arrière du circuit intégré quand la tension Vₒᵤₜ sur cette face arrière s'inverse. Toutefois, cette solution présente de nombreux inconvénients :
- la diode 51 n'est pas facile à intégrer ;
- l'insertion de cette diode 51 rajoute un seuil de diode (environ 0,6 volts) sur toutes les tensions d'entrée/sortie de la partie logique ; il en résulte par exemple que cette partie logique peut ne plus être compatible avec des signaux de commande de type TTL ;
- le circuit risque de ne plus fonctionner quand Vₒᵤₜ est négatif, Vᵢₛₒ étant alors à un potentiel flottant ; et
- comme l'illustrent les figures 1 et 2, il existe un transistor bipolaire parasite PNP Qp1 dont le collecteur correspond à la région d'isolement 26 ou 36, dont l'émetteur correspond au caisson 15 des transistors MOS de puissance, et dont la base correspond au substrat 1 du circuit intégré. Quand Vₒᵤₜ devient négatif, cet élément, disposé comme l'illustre la figure 3B en parallèle sur la diode 51, risque de se mettre en conduction et annule alors l'effet de cette diode 51.

Ainsi, un objet de la présente invention est de prévoir un circuit d'isolement intégré dans un circuit monolithique du type de ceux illustrés en figures 1 et 2 et permettant de maintenir l'isolement et le bon fonctionnement des parties logiques du circuit même quand la haute tension positive s'inverse.

Pour atteindre cet objet, la présente invention prévoit une structure intégrée, dite circuit d'isolation dynamique tel que défini dans la revendication 1, permettant de connecter automatiquement les régions d'isolement ou bien à la masse quand la haute tension de face arrière du circuit intégré est positive par rapport à la masse ou bien à cette tension de face arrière quand celle-ci devient négative par rapport à la masse. Plusieurs modes de réalisation avantageux de la présente invention sont définis dans les revendications dépendantes.

Les objets, caractéristiques et avantages de la présente invention seront exposés plus en détail dans la description suivante de modes de réalisation particuliers faite en relation avec les figures jointes parmi lesquelles :
les figures 1 à 3B, décrites précédemment, étaient destinées à illustrer l'état de la technique et le problème que la présente invention vise à résoudre ; parmi ces figures, les figures 1 et 2 représentent des structures classiques de circuits intégrés à transistors latéraux et verticaux et les figures 3A et 3B des schémas équivalents de l'isolement des caissons logiques ;

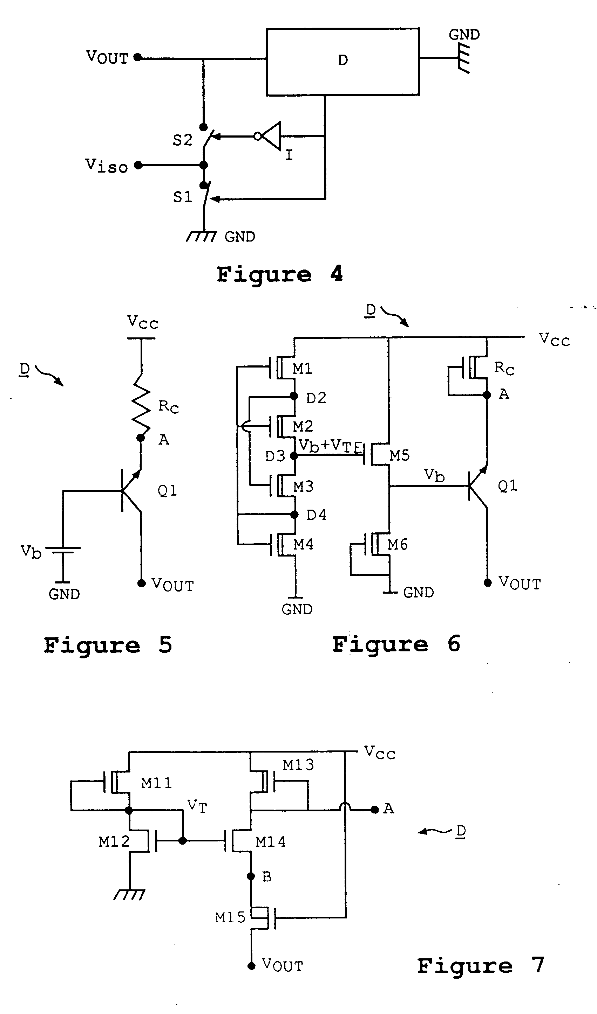

la figure 4 illustre la fonction que le circuit selon la présente invention accomplit ;
la figure 5 représente un exemple schématique de détecteur de polarité ;
la figure 6 représente un exemple plus détaillé de détecteur de polarité ;
la figure 7 représente un autre mode de réalisation de détecteur de polarité ;

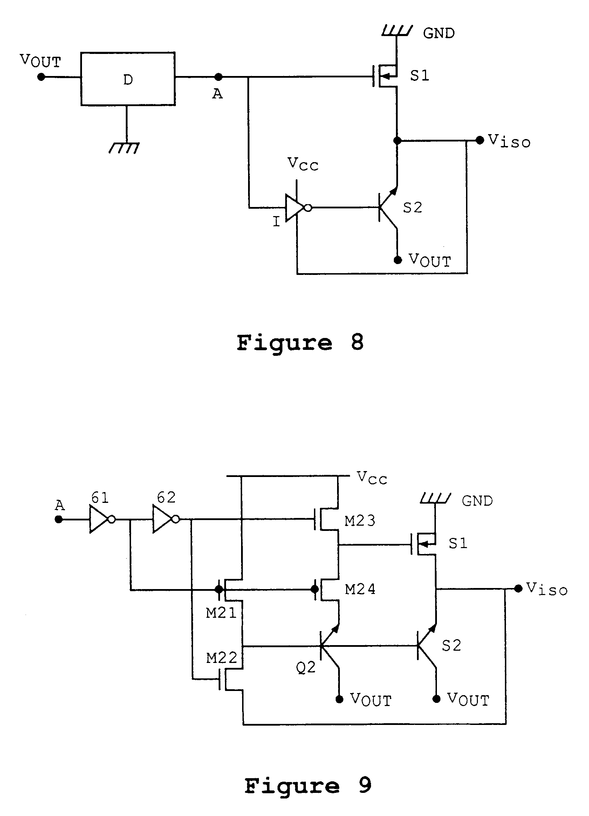

la figure 8 représente les éléments principaux d'un mode de réalisation de circuit selon la présente invention ;
la figure 9 représente de façon un peu plus détaillée les éléments principaux d'un mode de réalisation de circuit selon la présente invention ; et

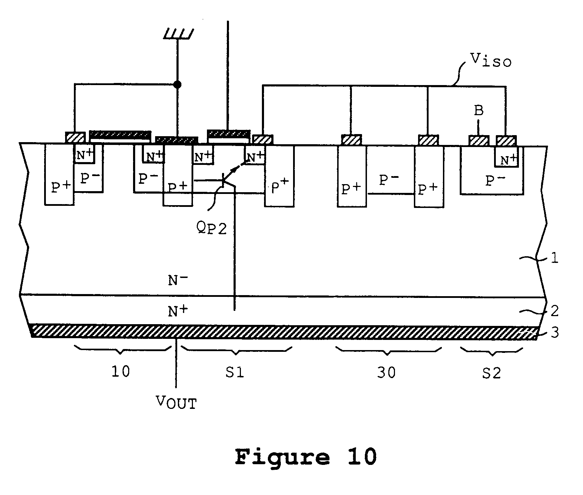

la figure 10 représente de façon schématique un exemple d'intégration d'un circuit selon la présente invention.

Comme le représente la figure 4, un circuit selon la présente invention comprend un détecteur de polarité D pour indiquer si le potentiel sur la face arrière d'un circuit intégré tel que celui des figures 1 et 2, comprenant des composants verticaux et latéraux, est positif ou négatif par rapport à la tension de référence du circuit, habituellement la masse, GND. Selon le résultat de la comparaison fournie par le détecteur D, la tension Vᵢₛₒ appliquée aux régions d'isolement (25, 26 ; 36) est ou bien la masse GND, connectée par l'intermédiaire d'un premier commutateur S1, ou bien la tension de face arrière Vₒᵤₜ connectée par l'intermédiaire d'un second commutateur S2. Un inverseur I permet de commander de façon opposée les commutateurs S1 et S2. Ainsi, le potentiel d'isolement Vᵢₛₒ est toujours relié au potentiel le plus négatif du circuit par l'intermédiaire d'un commutateur à faible impédance et le fonctionnement des circuits logiques continue à être satisfaisant quels que soient les parasites négatifs éventuels sur la face arrière.

### Exemples de réalisation du détecteur de polarité de face arrière

Un premier mode de réalisation du détecteur D est représenté de façon schématique en figure 5. Il comprend un transistor NPN vertical Q1, par exemple du type de celui représenté à gauche de la figure 2. Toutefois, ce transistor est utilisé en considérant que le collecteur a une fonction d'émetteur et l'émetteur une fonction de collecteur. Comme le représente la figure 2, le collecteur est relié par construction à la tension de face arrière Vₒᵤₜ. L'émetteur A, qui constitue la borne de sortie, est relié à la tension d'alimentation des circuits logiques, +VCC, par l'intermédiaire d'une résistance de charge R_{C} qui peut par exemple être un transistor MOS déplété.

Selon l'invention, la base du transistor Q1 est connectée à une source de tension V_{b} référencée à la masse, GND, et d'une valeur inférieure à la tension de conduction base-émetteur (VBE) d'un transistor NPN, soit une tension inférieure à 0,6 volt, par exemple 0,2 volt. Ainsi, tant que la tension Vₒᵤₜ est positive, le transistor Q1 est bloqué et le point A est au potentiel VCC (par exemple 5 à 15 V). Par contre, dès que la tension Vₒᵤₜ devient suffisamment négative pour que la tension entre base et émetteur (V_{b} - Vₒᵤₜ) du transistor Q1 devienne égale à une tension de seuil de diode (VBE), le transistor Q1 devient passant et le point A suit sensiblement le potentiel Vₒᵤₜ. Ainsi, on obtient sur la borne de sortie A du détecteur un signal sensiblement à la tension VCC quand Vₒᵤₜ est positif et un signal sensiblement à Vₒᵤₜ quand Vₒᵤₜ est négatif (plus négatif que 200 mV - VBE).

La figure 6 représente un exemple de schéma plus détaillé du circuit de la figure 5. Dans cette figure, on a symbolisé avec un trait vertical supplémentaire les transistors MOS à canal N déplétés. Le circuit de fourniture de la tension V_{b} (par exemple 200 millivolts) comprend quatre transistors MOS en série, trois transistors MOS déplétés M1, M2, M3 et un transistor MOS enrichi M4, connectés entre la tension VCC et la masse. Les grilles des transistors M1, M2 et M4 sont interconnectées et reliées à la connexion drain/source D4 des transistors M3 et M4. La grille du transistor M3 est reliée à la connexion drain/source D2 des transistors M1 et M2.

Le transistor M1 est un montage "cascode" qui génère à la source de M1 (point D2) une tension quasi-indépendante de la tension d'alimentation VCC. La cellule (M2, M3) est un circuit de génération de tension de référence du type "lambda cell" qui génère entre D3 et D4 une différence de potentiel V_{b} peu dépendante de la différence de potentiel V(D2) - V(D4). Le transistor M4 est un transistor enrichi à forte transconductance, dont le drain D4 se polarise à une tension peu différente de sa tension de seuil V_{TE}. La tension au point D3 s'établit donc à la valeur V_{TE} + V_{b}.

La tension V_{b} + V_{TE} au point D3 est appliquée à un circuit amplificateur de courant comprenant en série des transistors M5 et M6, le transistor M5 étant un transistor NMOS enrichi identique au transistor M4, et le transistor M6 étant un transistor NMOS déplété dont la grille est reliée à la source. La source du transistor M6 est reliée à la masse et le drain du transistor M5 est reliée à VCC. On obtient donc au point de connexion drain/source des transistors M5 et M6 la tension V_{b} que l'on veut appliquer à la base du transistor Q1 connecté, comme cela est représenté en figure 5, en série avec une résistance R_{c} réalisée sous forme d'un transistor MOS déplété dont la grille est reliée au drain.

Un autre exemple de réalisation du détecteur D est illustré en figure 7. Ce circuit comprend entre la tension VCC et la masse un transistor MOS déplété M11 et un transistor MOS enrichi M12. Les grilles des transistors M11 et M12 sont reliées ensemble à la connexion drain/source de ces transistors. On a donc sur cette connexion drain/source une tension proche de la tension de seuil V_{TE} d'un transistor MOS enrichi à canal N (le transistor M12). Ce circuit comprend d'autre part, entre la tension VCC et la face arrière (Vₒᵤₜ), un transistor MOS à canal N déplété M13, un transistor MOS à canal N enrichi M14 et un transistor MOS à canal N enrichi de type vertical (VDMOS) M15. La connexion entre les transistors M14 et M15 est désignée par la référence B. La grille du transistor M13 est reliée à la connexion drain/source des transistors M13 et M14 et constitue la borne de sortie A du détecteur. La grille du transistor M14 est reliée à la connexion drain/source des transistors M11 et M12, c'est-à-dire qu'elle est à un potentiel proche de V_{TE}. La grille du transistor VDMOS M15 est au potentiel VCC.

Le fonctionnement de ce circuit est le suivant. Lorsque Vₒᵤₜ est positif, la tension au point B est limitée à VCC moins la tension de seuil du VDMOS M15, c'est à dire VCC - VT_{VDMOS}. La tension de grille du transistor M14 étant alors inférieure à la tension source, celui-ci est bloqué et la tension au point A est égale à VCC.

Lorsque Vₒᵤₜ devient négatif, le transistor M15 est passant et la tension au point B est sensiblement égale à Vₒᵤₜ. Ainsi, le transistor M14 conduit un courant suffisant pour que la tension au point A chute à une tension très proche de Vₒᵤₜ.

### Exemple de réalisation des commutateurs

La figure 8 reprend de façon un peu plus détaillée le schéma d'ensemble de la présente invention précédemment représenté sous forme de blocs en figure 4.

Dans cette représentation, le commutateur S1 permettant d'établir la liaison entre la tension d'isolement Vᵢₛₒ et la masse GND quand Vₒᵤₜ est positif est réalisé par un transistor MOS latéral, et le commutateur S2 permettant d'établir la liaison entre la tension Vᵢₛₒ et le potentiel Vₒᵤₜ quand Vₒᵤₜ est négatif est réalisé par un transistor NPN vertical S2. Les autres références de ce circuit sont identiques à celles précédemment utilisées en figure 4. On notera que l'inverseur I est de préférence alimenté entre VCC et le potentiel Vᵢₛₒ, c'est-à-dire GND ou Vₒᵤₜ selon le signe de Vₒᵤₜ. Ceci permet de mieux garantir son fonctionnement dans le cas où Vₒᵤₜ est négatif.

La figure 9 reprend de façon un peu plus détaillée le circuit de la figure 8 étant donné qu'en pratique il faudra prévoir des étages amplificateurs et adaptateurs pour faire fonctionner le circuit de façon satisfaisante.

La borne A de sortie du détecteur D sur laquelle est disponible le potentiel Vₒᵤₜ (quand Vₒᵤₜ est négatif) ou VCC (quand Vₒᵤₜ est positif) est reliée à deux inverseurs 61 et 62.

Entre la tension d'alimentation VCC et le potentiel Vᵢₛₒ sont disposée en série des transistors MOS M21 et M22. Entre la tension d'alimentation VCC et la tension Vₒᵤₜ sont disposés en série un transistor MOS M23, un transistor MOS M24 et un transistor NPN Q2. La sortie de l'inverseur 61 commande les grilles des transistors M21 et M24. La sortie de l'inverseur 62 commande les grilles des transistors M22 et M23. Le point de connexion drain/source des transistors M21 et M22 commande les bases des transistors bipolaires Q2 et S2, qui sont tous les deux des transistors bipolaires NPN verticaux. Le point de connexion drain/source des transistors MOS M23 et M24 commande la grille du transistor MOS latéral S1.

Les transistors M21 et M22 constituent un premier étage d'amplificateur suiveur alors que les transistors M23, M24 et Q2 constituent un deuxième étage d'amplificateur suiveur. Ces étages sont destinés à assurer les courants de commande nécessaires et une commutation suffisamment rapide des commutateurs S1 et S2.

Quand le point A est au potentiel VCC (Vₒᵤₜ positif) les transistors M22 et M23 sont passants, les transistors M21 et M24 étant bloqués. Il en résulte que les transistors NPN Q2 et S2 sont bloqués tandis que le transistor S1 est passant. Le potentiel Vᵢₛₒ est alors bien fixé à la masse, GND, par l'intermédiaire du transistor S1.

Quand le point A est au potentiel négatif Vₒᵤₜ, l'état des transistors MOS M21, M22, M23, M24 s'inverse, la grille du commutateur S1 est à Vₒᵤₜ et la base des transistors bipolaires Q2 et S2 est à Vₒᵤₜ + VBE, c'est-à-dire que ce dernier transistor est rendu et que le potentiel Vᵢₛₒ est fixé au potentiel Vₒᵤₜ, ce qui est le résultat recherché.

Il résulte de ce qui précède, qu'en fait, la tension Vᵢₛₒ ne sera pas strictement égale à celle de la masse ou à celle de Vₒᵤₜ mais qu'elle n'en différera que d'une tension de quelques dizaines de millivolts, correspondant par exemple à la tension collecteur/émetteur à la saturation d'un transistor bipolaire ou à la chute de tension drain/source d'un transistor MOS à l'état passant.

L'homme de l'art notera que ce qui précède ne constitue qu'un exemple de réalisation de la présente invention. En ce qui concerne le transistor S1, celui-ci a été décrit précédemment comme un transistor MOS ; on pourrait également utiliser un transistor bipolaire à condition de modifier de façon appropriée son circuit de commande. De même, pour le transistor S2, on pourrait prévoir un transistor MOS vertical au lieu d'un transistor NPN vertical. Plus généralement, la présente invention peut être utilisée de la même façon avec des transistors respectivement à canal P pour les MOS latéraux et PNP pour les bipolaires verticaux.

La figure 10 représente de façon simplifiée un exemple d'intégration d'un circuit selon la présente invention, correspondant à la figure 8.

La figure 10 représente, de droite à gauche :
- un transistor NPN vertical S2 dont la base B reçoit la sortie du détecteur D,
- un caisson logique tel que le caisson 30 de la figure 2, dont les régions d'isolement sont reliées à la tension Vᵢₛₒ,
- un transistor MOS à canal N latéral constituant le commutateur S1, et
- une cellule de transistor VDMOS telle que la cellule 10 des figures 1 et 2.

Comme cela a été exposé précédemment, l'émetteur du transistor NPN vertical S2 est relié au potentiel Vᵢₛₒ qui est également relié au drain du transistor S1 dont la source est reliée à la masse, prise par exemple comme connexion de source de la cellule de VDMOS 10.

On notera que, selon une caractéristique supplémentaire de la présente invention, on préfère relier la région d'isolement P⁺ du transistor MOS latéral S1 à la masse et non pas à Vᵢₛₒ. En effet, en ce cas, quand Vₒᵤₜ devient négatif, le transistor bipolaire NPN parasite QP2 illustré en figure 10 devient conducteur et confirme la connexion de Vᵢₛₒ à Vₒᵤₜ.

## Revendications

1. Circuit d'isolation dynamique faisant partie d'un circuit intégré monolithique formé dans un substrat semiconducteur d'un premier type de conductivité comprenant des transistors latéraux dont les bornes sont accessibles par la face avant du substrat et des transistors verticaux dont une borne de puissance correspond à la face arrière du substrat, les transistors latéraux étant isolés, individuellement ou en groupes, par une région d'isolement du deuxième type de conductivité (26 ; 36) reliée à un potentiel dit potentiel d'isolement (Vᵢₛₒ), ces transistors latéraux étant connectés à des tensions d'une première polarité par rapport à une tension de référence (GND), la borne de puissance connectée à la face arrière (3) étant également normalement à un potentiel (Vₒᵤₜ) de la première polarité par rapport à la tension de référence, caractérisé en ce qu'il comprend :
des moyens de détection (D) du signe du potentiel de la face arrière par rapport à la tension de référence,
des premiers moyens de commutation (S1) comprenant au moins un transistor latéral pour relier le potentiel d'isolement au potentiel de référence quand le potentiel de la face arrière est de la première polarité par rapport au potentiel de référence,
des seconds moyens de commutation (S2) comprenant au moins un transistor vertical pour relier le potentiel d'isolement au potentiel de la face arrière quand le potentiel de la face arrière est de la deuxième polarité par rapport au potentiel de référence.

2. Circuit d'isolation dynamique selon la revendication 1, caractérisé en ce que le potentiel de référence est la masse, la face arrière du circuit intégré correspond à une couche de type N⁺ et la région d'isolement est de type P, la première polarité étant la polarité positive, et les transistors latéraux sont connectés à une tension d'alimentation positive normale (VCC).

3. Circuit d'isolation dynamique selon la revendication 2, caractérisé en ce que les moyens (D) de détection du signe du potentiel de la face arrière par rapport à la masse comprennent un transistor vertical NPN (Q1) dont le collecteur est relié à la face arrière, la base est polarisée à une tension positive déterminée (V_{b}) inférieure à la tension base-émetteur à l'état passant (VBE) d'un transistor NPN, et l'émetteur est relié à la tension d'alimentation positive normale (VCC) des transistors latéraux par l'intermédiaire d'un élément de charge (R_{c}); le signal de détection étant fourni au point de connexion dudit émetteur et dudit élément de charge (R_{c}).

4. Circuit d'isolation dynamique selon la revendication 2, caractérisé en ce que les moyens (D) de détection du signe du potentiel de la face arrière par rapport à la masse comprennent un transistor VDMOS à canal N (M15) dont le drain est relié à la face arrière et la source est connectée à un transistor NMOS latéral (M14) dont l'autre borne principale est reliée à la tension d'alimentation positive normale des transistors latéraux par l'intermédiaire d'un élément de charge (M13) ; la grille du transistor VDMOS à canal N (M15) étant polarisée à la tension d'alimentation positive normale des transistors latéraux (VCC) et la grille du transistor NMOS latéral (M14) étant polarisée à une valeur peu supérieure à sa tension de seuil (V_{T}) ; le signal de détection étant fourni au point de connexion du transistor NMOS latéral (M14) et de l'élément de charge (M13).

5. Circuit d'isolation dynamique selon la revendication 2, caractérisé en ce que les premiers moyens de commutation (S1) comprennent dans un caisson du type P un transistor MOS canal N à enrichissement dont la source est reliée au potentiel de référence, dont le drain est connecté aux régions d'isolement et dont la grille est commandée par les moyens de détection de signe (D).

6. Circuit d'isolation dynamique selon la revendication 5, caractérisé en ce que le caisson dudit transistor MOS est relié au potentiel de référence (GND).

7. Circuit d'isolation dynamique selon la revendication 2, caractérisé en ce que les seconds moyens de commutation (S2) comprennent un transistor bipolaire vertical NPN dont l'émetteur est connecté à la face arrière du substrat, dont le collecteur est connecté aux régions d'isolement et dont la base est commandée à travers un dispositif inverseur par les moyens de détection de signe (D).

8. Circuit d'isolation dynamique selon la revendication 2, caractérisé en ce que les seconds moyens de commutation (S2) comprennent un transistor MOS vertical à canal N dont le drain est connecté à la face arrière, dont la source est connectée au potentiel d'isolement et dont la grille est commandée à travers un inverseur par les mayens de détection de signe (D).

## Patentansprüche

1. Dynamische Isolierschaltung, welche Teil eines monolithischen integrierten Schaltkreises in einem Halbleitersubstrat einer ersten Leitfähigkeitsart ist, mit seitlichen Transistoren, deren Anschlüsse von der Vorderseite des Substrates zugänglich sind, und vertikalen Transistoren, bei denen ein Leistungsanschluß der Rückseite des Substrates entspricht, wobei die seitlichen Transistoren einzeln oder in Gruppen durch einen Isolationsbereich der zweiten Leitfähigkeitsart (26;36) isoliert sind, der mit einem als Isolationspotential (Vᵢₛₒ) bezeichneten Potential verbunden ist, wobei die seitlichen Transistoren mit Spannungen verbunden sind, welche bezüglich einer Bezugsspannung (GND) eine erste Polarität aufweisen, und der mit der Rückseite (3) verbundene Leistungsanschluß normalerweise ebenfalls mit einem Potential (Vₒᵤₜ) verbunden ist, das bezüglich der Bezugsspannung die erste Polarität aufweist, **gekennzeichnet** durch
eine Vorrichtung (D) zum Erfassen des Vorzeichens des Potentials der Rückseite relativ zu der Bezugsspannung,
eine erste Schaltvorrichtung (S1), welche mindestens einen seitlichen Transistor umfaßt, um das Isolationspotential mit dem Bezugspotential zu verbinden, wenn das Potential der Rückseite relativ zu dem Bezugspotential die erste Polarität aufweist,
eine zweite Schaltvorrichtung (S2), welche mindestens einen vertikalen Transistor aufweist, um das Isolationspotential mit dem Potential der Rückseite zu verbinden, wenn das Potential der Rückseite relativ zu dem Bezugspotential die zweite Polarität aufweist.

2. Dynamische Isolierschaltung nach Anspruch 1, dadurch **gekennzeichnet,** daß das Bezugspotential Masse ist, die Rückseite der integrierten Schaltung einer N⁺- Schicht entspricht und der Isolationsbereich ein P-Bereich ist, die erste Polarität die positive Polarität ist, und die seitlichen Transistoren mit einer üblichen positiven Versorgungsspannung (VCC) verbunden sind.

3. Dynamische Isolierschaltung nach Anspruch 2, dadurch **gekennzeichnet,** daß die Vorrichtung (D) zum Erfassen des Vorzeichens des Potentials der Rückseite relativ zur Masse einen vertikalen NPN-Transistor (Q1) aufweist, dessen Kollektor mit der Rückseite verbunden ist, dessen Basis auf eine vorgegebene positive Spannung (Vb) vorgespannt ist, welche geringer ist als die Basis-Emitter-Spannung im leitenden Zustand (VBE) eines NPN-Transistors, und dessen Emitter mit der üblichen positiven Versorgungsspannung (VCC) der seitlichen Transistoren mittels eines Lastelementes (Rc) verbunden ist, wobei das Erfassungssignal am Verbindungspunkt des Emitters und des Lastelementes (Rc) bereitgestellt wird.

4. Dynamische Isolierschaltung nach Anspruch 2, dadurch **gekennzeichnet,** daß die Vorrichtung (D) zum Erfassen des Vorzeichens des Potentials der Rückseite relativ zur Masse einen N-Kanal-VDMOS-Transistor (M15) aufweist, dessen Drain mit der Rückseite verbunden ist und dessen Source mit dem seitlichen NMOS-Transistor (M14) verbunden ist, dessen anderer Hauptanschluß mit der üblichen positiven Versorgungsspannung der seitlichen Transistoren über ein Lastelement (M13) verbunden ist; das Gate des N-Kanal-VDMOS-Transistors (M15) auf die übliche positive Versorgungsspannung der seitlichen Transistoren (VCC) vorgespannt ist und das Gate des seitlichen NMOS-Transistors (M14) auf einen Wert vorgespannt ist, der geringfügig größer ist als dessen Schwellwertspannung (V_{T}); das Erfassungssignal an dem Verbindungspunkt des seitlichen NMOS-Transistors (M14) und des Lastelementes (M13) bereitgestellt wird.

5. Dynamische Isolierschaltung nach Anspruch 2, dadurch **gekennzeichnet**, daß die erste Schaltvorrichtung (S1) in einem P-Caisson einen MOS-Transistor mit angereichertem N-Kanal aufweist, dessen Source mit dem Bezugspotential verbunden ist, dessen Drain mit den Isolationsbereichen verbunden ist und dessen Gate von der Vorrichtung zur Erfassung des Vorzeichens (D) angesteuert wird.

6. Dynamische Isolierschaltung nach Anspruch 5, dadurch **gekennzeichnet**, daß der Caisson des MOS-Transistors mit dem Bezugspotential (GND) verbunden ist.

7. Dynamische Isolierschaltung nach Anspruch 2, dadurch **gekennzeichnet**, daß die zweite Schaltvorrichtung (S2) einen vertikalen bipolaren NPN-Transistor aufweist, dessen Emitter mit der Rückseite des Substrats verbunden ist, dessen Kollektor mit den Isolationsbereichen verbunden ist und dessen Basis über eine Invertervorrichtung von der Vorrichtung zum Erfassen des Vorzeichens (D) angesteuert wird.

8. Dynamische Isolierschaltung nach Anspruch 2, dadurch **gekennzeichnet**, daß die zweite Schaltvorrichtung (S2) einen vertikalen N-Kanal-MOS-Transistor aufweist, dessen Drain mit der Rückseite verbunden ist, dessen Source mit dem Isolationspotential verbunden ist und dessen Gate über einen Inverter von der Vorrichtung zum Erfassen des Vorzeichens (D) angesteuert wird.

## Claims

1. A dynamic isolation circuit incorporated in a monolithic integrated circuit formed in a semiconductive substrate of a first conductivity type comprising lateral transistors whose terminals are accessible from the front face of the substrate and vertical transistors, one power terminal of which corresponds to the rear face of the substrate, the lateral transistors being isolated, individually or in groups, by an isolating region of the second conductivity type (26 ; 36) connected to a potential, referred to as an isolating potential (Vᵢₛₒ), these lateral transistors being connected to voltages of a first polarity relative to a reference voltage (GND), the power terminal connected to the rear face (3) also normally being at a potential (Vₒᵤₜ) of the first polarity relative to the reference voltage, characterized in that it comprises :
means (D) for detecting the sign of the potential of the rear face relative to said reference voltage,
first switching means (S1) comprising at least one lateral transistor to connect said isolating potential to said reference potential when the potential of the rear face is of the first polarity relative to said reference potential,
second switching means (2) comprising at least one vertical transistor to connect said isolating potential to the potential of the rear face when the potential of the rear face is of the second polarity relative to said reference potential.

2. A dynamic isolation circuit according to claim 1, characterized in that said reference potential is earth, the rear face of the integrated circuit corresponds to an n⁺-type layer and said isolating region is of p-type, said first polarity being the positive polarity, and the lateral transistors are connected to a normal positive supply voltage (VCC).

3. A dynamic isolation circuit according to claim 2, characterized in that said means (D) for detecting the sign of the potential of the rear face relative to earth comprise a vertical npn transistor (Q1) whose collector is connected to the rear face, the base is biased to a specified positive voltage (V_{b}) less than the base-emitter voltage in the on state (VBE) of an npn transistor, and the emitter is connected to the normal positive supply voltage (VCC) of the lateral transistors by way of a load element (R_{c}), the detection signal being provided to the junction of said emitter and said load element (R_{c}).

4. A dynamic isolation circuit according to claim 2, characterized in that said means (D) for detecting the sign of the potential of the rear face relative to earth comprise an n-channel VDMOS transistor (M15) whose drain is connected to the rear face and whose source is connected to a lateral NMOS transistor (M14) whose other main terminal is connected to the normal positive supply voltage of the lateral transistors through a load element (M13) ; the gate of the n-channel VDMOS transistor (M15) being biased to the normal positive supply voltage of the lateral transistors (VCC) and the gate of the lateral NMOS transistor (M14) being biased to a value slightly greater than its threshold voltage (V_{T}); the detection signal being provided to the junction of the lateral NMOS transistor (M14) and the load element (M13).

5. A dynamic isolation circuit according to claim 2, characterized in that said first switching means (S1) comprise, in a p-type caisson, an enhanced n-channel MOS transistor whose source is connected to the reference potential, whose drain is connected up to the isolating regions and whose gate is controlled by the sign-detecting means (D).

6. A dynamic isolation circuit according to claim 5, characterized in that the caisson of said MOS transistor is connected to the reference potential (GND).

7. A dynamic isolation circuit according to claim 2, characterized in that said second switching means (S2) comprise a vertical npn bipolar transistor whose emitter is connected to the rear face of the substrate, whose collector is connected to the isolating regions and whose base is controlled through an inverter device by said sign-detecting means (D).

8. A dynamic isolation circuit according to claim 2, characterized in that said second switching means (S2) comprise a vertical n-channel MOS transistor whose drain is connected to the rear face, whose source is connected to the isolating potential and whose gate is controlled through an inverter by said sign-detecting means (D).
